(19) Europäisches Patentamt
European Patent Office
Office européen des brevets

(11) **EP 2 011 894 A1**

(12) **EUROPEAN PATENT APPLICATION**

(43) Date of publication:
**07.01.2009 Bulletin 2009/02**

(51) Int Cl.:
**C23C 14/06** (2006.01)       **C22C 29/00** (2006.01)
**C23C 16/34** (2006.01)       **C23C 30/00** (2006.01)

(21) Application number: **08156044.3**

(22) Date of filing: **12.05.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority:  **01.06.2007  SE 0701320**
**15.06.2007  SE 0701449**
**27.06.2007  SE 0701548**
**23.07.2007  SE 0701760**

(71) Applicant: **Sandvik Intellectual Property AB**
**81181 Sandviken (SE)**

(72) Inventors:
• **Ahlgren, Mats**
**187 67 Täby (SE)**

• **Nordgren, Susanne**
**141 41 Huddinge (SE)**
• **Nordgren, Anders**
**121 34 Enskede (SE)**
• **Ljungberg, Ann-Britt**
**113 27 Stockholm (SE)**
• **Jonsson, Anders**
**803 11 Gävle (SE)**
• **Malm, Ann-Marie**
**811 60 Sandviken (SE)**
• **Blom, Bo**
**747 40 Gimo (SE)**
• **Hansson, Martin**
**802 80 Gävle (SE)**

(74) Representative: **Hägglöf, Henrik**
**Sandvik Intellectual Property AB**
**811 81 Sandviken (SE)**

(54) **Cemented carbide inserts for parting, grooving and threading**

(57)    The present invention relates to a cutting insert for parting, grooving and threading in steel and stainless steels comprising a substrate and a coating. The substrate comprises WC, 7.5-10.5 wt-% Co, 0.7-1.1 wt-% Cr and 100-300 ppm Ti. Ti may partly be replaced by Ta to a weight ratio Ti/Ta of $\geq$0.8. The coating comprises two (Ti,Al)N-layers with different Al/Ti-ratios: an inner $Al_yTi_{1-y}N$-layer with y=0.4-0.67 with a thickness of 0.3-2.5 $\mu$m and an outer $Al_wTi_{1-w}N$ layer with w=0.15-0.35 with a thickness of 0.5-5.0 $\mu$m.

EP 2 011 894 A1

**Description**

The present invention relates to a coated cutting tool insert particularly useful for parting, grooving and threading in steel, stainless steels and heat resistant super alloys (HRSA) under wet conditions. A multilayered PVD-coating greatly improves the flank wear resistance and a high chromium fine grained substrate provides good resistance against plastic deformation.

Coated cutting tool inserts for parting, grooving and threading in a big variation of work materials as steel, stainless steels and HRSA must have the following properties:

1. High resistance against plastic deformation, since the cutting process generates a high temperature in the cutting edge of the insert, especially in the nose area when threading.
2. Good resistance against abrasive wear in order to avoid a rapidly growing flank wear.
3. Good resistance against adhesion wear and very good adhesion between the substrate and the coating. The chips from especially stainless steels are very prone to welding onto the surface of the insert.
4. Good edge line toughness in order to avoid breakage and chipping.
5. Good bulk toughness in order to avoid bulk breakage especially when cutting off to centre.

US 6,261,673 discloses a coated cemented carbide insert useful for grooving or parting of steel components such as steel or stainless steel tubes and bars. The insert is characterised by a WC-Co-based cemented carbide substrate having a highly W-alloyed Co-binder phase and a relatively thin coating including an inner layer of $TIC_xN_yO_z$ with columnar grains followed by a layer of fine grained $\kappa$-$Al_2O_3$ and a top layer of TiN.

US 6,342,291 discloses a coated cutting tool useful for grooving or parting of steel components such as steel or stainless steel tubes and bars. The insert is characterised by a WC-Co-based cemented carbide substrate having a highly W-alloyed Co-binder phase and a hard and wear resistant coating including a multilayered structure of sublayers of the composition $(Ti_xAl_{1-x})N$ with repeated variation of the Ti/Al ratio.

EP-A-1798310 discloses a cutting insert for parting and grooving in heat resistant super alloys and stainless steels comprising a substrate and a coating. The substrate comprises 5-7 wt-% Co, 0.15-0.60 wt-% TaC, 0.10-0.50 wt-% NbC and balance WC. The coating consists of a homogeneous $Al_xTi_{1-x}N$-layer with x=0.6-0.7 and a thickness of 1-3.8 μm.

It is an object of the present invention to provide a cutting tool insert useful for parting, grooving and threading in steel, stainless steels, and HRSA, under wet conditions.

It is a further object of the present invention to provide a cutting tool insert with improved resistance against plastic deformation and wear resistance.

It is yet a further object of the present invention to provide a cutting tool where the improved resistance against plastic deformation has not been obtained at the expense of lowered edge line toughness.

It has now been found that a multilayered (Ti,Al)N PVD-coating in combination with a high chromium fine grained substrate provides good resistance against plastic deformation, good wear resistance and sufficient edge line toughness when parting, grooving and threading under wet conditions in steel, stainless steels and HRSA.

The present invention thus relates to a coated cutting tool insert consisting of a cemented carbide substrate and a coating. The cemented carbide substrate comprises, preferably consists of, WC, 7.5-10.5 wt-% Co, preferably 8.0-10.0 wt-% Co, most preferably 8.5-9.5 wt-% Co, and 0.7-1.1 wt-% Cr, preferably 0.8-1.0 wt-% Cr. The cemented carbide further contains 100-300 ppm Ti, preferably 150-275 ppm Ti, most preferably 200-260 ppm Ti. In another embodiment a part of the Ti is replaced by Ta with a weight ratio Ti/Ta of ≥0.8, preferably ≤1.7, most preferably 1.2-1.5.

The binder phase is alloyed with W and Cr which influences the magnetic properties of the binder and can hence be related to a value, CW_Cr ratio, defined as

$$CW\_Cr= \text{(magnetic-\% Co} +1.13*\text{wt-\%Cr)/wt-\%Co}$$

where magnetic-% Co is the weight percentage of magnetic Co, wt-% Cr is the weight percentage of Cr in the cemented carbide and wt-% Co is the weight percentage of Co in the cemented carbide.

It has been found that improved cutting performance is achieved if the cemented carbide has a CW_Cr-ratio of 0.77-0.97, preferably 0.80-0.94, most preferably 0.82-0.92 and a coercivity of 21-27 kA/m, preferably 22-26, kA/m.

The sintered body may also contain small amounts of precipitations of additional phase or phases such as eta-phase, MX or $M_7X_3$, $M_3X_2$ where M=(Ti+Ta+Co+Cr+W) with X=C or N, and may be allowed to a volume fraction of maximum 0.5 vol-% without detrimental effects.

The coating comprises two (Ti,Al)N-layers with different Al/Ti-ratios. The inner layer has a higher Al/Ti-ratio than the outer layer. The inner layer consists of an $Al_yTi_{1-y}N$-layer with y=0.4-0.67, preferably 0.45-0.60. The coating thickness of the inner layer is 0.3-2.5 $\mu$m, preferably 0.5-2.0 $\mu$m. In one preferred embodiment the inner layer is an aperiodic lamella coating consisting of alternating layers of $Al_zTi_{1-z}N$ and $Al_vTi_{1-v}N$ where z=0.55-0.70, preferably z=0.6-0.67, and v=0.35-0.53, preferably v=0.40-0.50. The coating thickness of each individual layer is 0.1-20 nm, preferably 1-10 nm. The outer layer consists of an $Al_wTi_{1-w}N$ layer with w=0.15-0.35, preferably w=0.20-0.30. The coating thickness of the outer layer is 0.5-5.0 $\mu$m, preferably 1.0-4.0 $\mu$m. In one preferred embodiment the outer layer consists of an aperiodic lamella coating with alternating layers of $Al_mTi_{1-m}N$, $Al_nTi_{1-n}N$ and $Al_kTi_{1-k}N$ where m=0-0.2, preferably m=0-0.1, n=0.35-0.53, preferably n=0.40-0.50, k=0.55-0.70, preferably k=0.6-0.67. The coating thickness of each individual layer is 0.1-20 nm, preferably 1-10 nm. The total thickness of the coating is 0.8-7.5 $\mu$m, preferably 1.5-6.0 $\mu$m. The thickness of the individual layers is measured on the flank face 0.2 mm below the cutting edge.

In one preferred embodiment the coating has an innermost adhesion layer consisting of a TiN-layer, with the thickness of 0.05-0.2 $\mu$m, preferably 0.1-0.2 $\mu$m.

In one embodiment the coating has a top layer of TiN for colour purpose. The thickness of the TiN-layer is 0.1-1 $\mu$m, preferably 0.1-0.3 $\mu$m.

In another embodiment the coating has a top layer of $Al_pTi_{1-p}N$ for colour purpose with p=0.05-0.67. The thickness of the $Al_pTi_{1-p}N$ -layer is 0.2-1 $\mu$m, preferably 0.2-0.4 $\mu$m.

The present invention also relates to a method of making a coated cutting tool insert consisting of a cemented carbide substrate and a coating. The cemented carbide substrate is made using conventional powder metallurgical techniques milling, pressing and sintering. The cemented carbide substrate comprises, preferably consists of, WC, 7.5-10.5 wt-% Co, preferably 8.0-10.0 wt-% Co, most preferably 8.5-9.5 wt-% Co and 0.7-1.1 wt-% Cr, preferably 0.8-1.0 wt-% Cr. In one embodiment the cemented carbide further contains 100-300 ppm Ti, preferably 150-275 ppm Ti, most preferably 200-260 ppm Ti. In another embodiment a part of the Ti is replaced by Ta with a weight ratio Ti/Ta of >0.8, preferably ≤1.7, most preferably 1.2-1.5, added as TaC,(Ta,W)C, TiC,(Ti,W)C and/or (Ti,Ta,W)C or combinations of these. After sintering in vacuum for 1 hour at 1410 °C the coercivity is 21-27 kA/m, preferably 22-26 kA/m.

The CW_Cr-ratio is 0.77-0.97, preferably 0.80-0.94, most preferably 0.82-0.92, and is monitored by adding suitable amounts of carbon black or tungsten powder to the powder mixture.

After conventional post sintering treatment the coating consisting of two (Ti,Al)N-layers with different Al/Ti-ratios are deposited with cathodic arc evaporation or magnetron sputtering. The inner layer has a higher Al/Ti-ratio than the outer layer. The inner layer consists of an $Al_yTi_{1-y}N$-layer with y=0.4-0.67, preferably 0.45-0.60. The coating thickness of the inner layer is 0.3-2.5 $\mu$m, preferably 0.5-2.0 $\mu$m. In one preferred embodiment the inner layer is an aperiodic lamella coating consisting of alternating layers of $Al_zTi_{1-z}N$ and $Al_vTi_{1-v}N$ where z=0.55-0.70, preferably z=0.6-0.67 and v=0.35-0.53, preferably v=0.40-0.50. The coating thickness of each individual layer is 0.1-20 nm, preferably 1-10 nm. The outer layer consists of an $Al_wTi_{1-w}N$ layer with w=0.15-0.35, preferably w=0.20-0.30. The coating thickness of the outer layer is 0.5-5.0 $\mu$m, preferably 1.0-4.0 $\mu$m. In one preferred embodiment the outer layer consists of an aperiodic lamella coating with alternating layers of $Al_mTi_{1-m}N$, $Al_nTi_{1-n}N$ and $Al_kTi_{1-k}N$ where m=0-0.2, preferably m=0-0.1, n=0.35-0.53 preferably n=0.40-0.50, k=0.55-0.70, preferably k=0.6-0.67. The coating thickness of each individual layer is 0.1-20 nm, preferably 1-10 nm. The total thickness of the coating is 0.8-7.5 $\mu$m, preferably 1.5-6.0 $\mu$m.

The present invention also relates to the use of the insert according to above for parting, grooving and threading under wet conditions in steel and stainless steels at a cutting speed of 30-400 m/min and a feed of 0.05-0.6 mm/rev and in HRSA at a cutting speed of 15-100 m/min and a feed of 0.02-0.3 mm/rev.

Example 1 (invention)

A1. A multilayer (Ti,Al)N-coating was deposited by cathodic arc evaporation on cutting inserts made of cemented carbide with a composition of 9 wt-% Co, 0.9 wt-% Cr, 230 ppm Ti and balance WC and a coercivity of 23.6 kA/m corresponding to an average grain size of about 0.8 $\mu$m and a magnetic Co-content of 6.7 corresponding to a CW_Cr-ratio of 0.95. The coating was deposited using arc evaporation of Ti and TiAl metal sources. A TiN adhesion layer was deposited using Ti metal sources in a mixed Ar and $N_2$ atmosphere. The coating thickness of the TiN adhesion layer was 0.15 $\mu$m. A second layer was deposited in a $N_2$ atmosphere using targets consisting of $Al_{0.67}Ti_{0.33}$ and $Al_{0.50}Ti_{0.50}$ alloy. An aperiodic lamella structure was obtained by a 3-fold rotation of the inserts inside the deposition chamber. The thickness of the second layer was 1.6 $\mu$m. The average composition was $Al_{0.54}Ti_{0.46}N$ as determined by SEM-EDS. The average thickness of the individual lamella layers of the second layer was 8 nm as determined by transmission electron microscopy (TEM). The third outer layer was deposited in a $N_2$ atmosphere using targets consisting of Ti, $Al_{0.67}Ti_{0.33}$ and $Al_{0.50}Ti_{0.50}$ alloy. An aperiodic lamella structure was obtained by a 3-fold rotation of the inserts inside the deposition chamber. The thickness of this third layer was 2.6 $\mu$m. The average composition of the third layer was $Al_{0.24}Ti_{0.76}$ as determined by SEM-EDS. The average thickness of the individual lamella layers of the third layer was 11 nm as determined by TEM. The total thickness of the applied coating was 4.4 $\mu$m.

A2. The same coating as in A1 was deposited on a cemented carbide with a composition of 9 wt-% Co, 0.9 wt-% Cr, 130 ppm Ti, 100 ppm Ta and balance WC.

Example 2 (prior art)

B. Cemented carbide grooving inserts composed of a cemented carbide substrate consisting of 10 wt-% Co, 0.39 wt-% Cr and balance WC with a coercivity of 20 kA/m and a CW Cr of 0.89 corresponding to a grain size of 0.9 $\mu$m and a hardness of 1600 HV3 were coated with a 4.4 $\mu$m PVD (Ti,Al)N multilayer consisting of a sequence of homogeneous $Al_{0.5}Ti_{0.5}N$ layers and lamella layers with alternating layers of TiN and $Al_{0.5}Ti_{0.5}N$. This sequence was repeated twelve times. The thickness of the homogeneous $Al_{0.5}Ti_{0.5}N$ -layers was 0.1-0.2 $\mu$m and the thickness of the lamella layers was 0.1-0.2 $\mu$m. The thickness of each individual TiN or $Al_{0.5}Ti_{0.5}N$ - layer in the lamella layer was 0.1-20 nm. The average composition of the multilayer was $Al_{0.2}Ti_{0.8}N$ measured with SEM-EDS.

Example 3

Inserts A1 and B were tested in grooving and turning of a quenched and tempered steel component. The first operation is a 2 mm deep groove from outer diameter 46 mm, then turning 20 mm along the bar, then grooving and turning back, so on into diameter 10.2 mm.

| Operation: | Grooving and turning |
| --- | --- |
| Material: | AISI 4340 (SS 2541-03) |
| Insert-style: | N123G2-0300-0003-TF |
| Cutting speed: | 220 m/min |
| Feed grooving: | 0.15 mm/r |
| Feed turning: | 0.13 mm/r |
| Time per component: | 28 s |
| With coolant | |

Results in number of finished components and tool life in minutes:

| Grade A1 (invention) | 86.7 components, 40.5 min in cut |
| --- | --- |
| Grade B (prior art) | 46.7 components, 21.8 min in cut |

Example 4

Inserts A1 and B were tested in grooving of a quenched and tempered steel. The outer diameter of the groove, Do, was 178 mm, the inner diameter, $D_i$, 172 mm and the width of the groove 3 mm.

| Operation: | Grooving |
| --- | --- |
| Material: | AISI 4340 (SS 2541-03) |
| Insert-style: | N123G2-0300-0003-TF |
| Cutting speed: | 210 m/min |
| Feed grooving: | 0.12 mm/r |
| Cutting depth: | 3 mm |
| Time per cycle: | 3 min (1 cycle is 30 grooves) |
| With coolant | |

Results: The tool life at a predetermined flank wear of 0.2 mm. Grade A1 was run 21.3 cycles and total time in cut was 63.9 min. The tool life of inserts B was 11.3 cycles and these were finished in 33.9 min.

Example 5

Insert A1 and B were tested in grooving and turning of an austenitic stainless steel component. The first operation is a 2 mm deep groove from outer diameter 45 mm, then turning 20 mm along the bar, then grooving and turning back, so on into diameter 10.2 mm.

Operation: Grooving and turning
Material: SANMAC 316L
Insert-style: N123H2-0400-0008-TM
Cutting speed: 180 m/min
Feed grooving: 0.15 mm/r
Feed turning: 0.15 mm/r
Time per component: 27 s
With coolant

Results in number of finished components and tool life in minutes:

Grade A1 (invention) 70 components, 31.5 min in cut
Grade B (prior art) 51 components, 23.3 min in cut

Example 6

Inserts A1 and B were tested in grooving of steel with Do 159 mm, Di 140 mm and width 9.5 mm.

Operation: Grooving
Material: SN2039
Insert-style: N123L2-0800-RM
Cutting speed: 150-130 m/min
Feed: 0.3 mm/r
Time per component: 90 s
With coolant

Results in number of finished components and tool life in minutes:

Grade A1 (invention) 71 components, 106.5 min in cut
Grade B (prior art) 34 components, 51 min in cut

Example 7

Inserts A1 and B were tested in internal threading M24 X 1,5 length 24 mm in Steel C40, hardness 190-250 HB.

Operation: Internal threading
Material: C40
Insert-style: R166.OL-16MM01-150
Cutting speed: 115 m/min
Number of passes: 7 per thread
With coolant

Results in number of threads:

Grade A1 (invention): 580 threads
Grade B (prior art) : 430 threads

Example 8

Inserts A2 and B were tested in grooving of steel from Do 177.9 mm to Di 165.8 mm. The width of the grooves was 12.45 mm.

| Operation: | Grooving |
|---|---|
| Material: | 16MnCr5 |
| Insert-style: | N123H2-0400-0004-TF |
| Cutting speed: | 255 m/min |
| Feed: | 0.15 mm/r |
| Time per component: | 17 s |
| With coolant | |

Results in number of components and tool life in minutes at a predetermined surface finish:

| Grade A2 (invention): | 107 components, 30.3 min in cut |
|---|---|
| Grade B (prior art) : | 75 components, 21.3 min in cut |

Example 9

Inserts A2 and B were tested in parting off a steel bar from Do 20 mm to centre.

| Operation: | Parting off |
|---|---|
| Material: | 42CrMo4, Hardness 320 HB |
| Insert-style: | N123G2-0300-0002-CM |
| Cutting speed: | From 100 m/min to 0 m/min |
| Feed: | 0.15 mm/r, from diam 3 mm f = 0.05 mm/r |
| Time per component: | 4 s |
| With coolant | |

Results in number of components and tool life in minutes:

| Grade A2 (invention): | 6200 components, 413 min in cut |
|---|---|
| Grade B (prior art) : | 3600 components, 240 min in cut |

Example 10

Inserts A2 and B were tested in parting off a steel tube from Do 36 mm to $D_i$ 17 mm.

| Operation: | Parting off tube |
|---|---|
| Material: | 42CD4, Hardness 300 HB |
| Insert-style: | N123G2-0300-0003-CR |
| Cutting speed: | 150 m/min |
| Feed: | 0.1 mm/r |
| Time per component: | 3.2 s |
| With coolant | |

Results in number of components and tool life in minutes:

| Grade A2 (invention): | 1159 components, 61.8 min in cut |
|---|---|
| Grade B (prior art) : | 754 components, 40.2 min in cut |

Example 11

Inserts A2 and B were tested in parting off a steel tube from Do 120 mm to $D_i$ 115 mm.

| | |
|---|---|
| Operation: | Parting off tube |
| Material: | SAE1010, Hardness 110 HB |
| Insert-style: | N123G2-0300-0003-CR |
| Cutting speed: | From 226 m/min to 216 m/min |
| Feed: | 0.15 mm/r |
| Time per component: | 1.67 s |
| With coolant | |

Results in number of components and tool life in minutes:

| | |
|---|---|
| Grade A2 (invention): | 700 components, 19 min in cut |
| Grade B (prior art) : | 580 components, 16 min in cut |

Example 12

Inserts A2 and B were tested in parting off a 20 mm Inconel pin.

| | |
|---|---|
| Operation: | Parting off pin |
| Material: | Inconel 718 |
| Insert-style: | N123G2-0300-0002-CM |
| Cutting speed: | 20 m/min |
| Feed: | 0.07 to 0.03 mm/r |
| With coolant | |

Results in number of components:

| | |
|---|---|
| Grade A2 (invention): | 100 pins |
| Grade B (prior art) : | 85 pins |

**Claims**

1. Cutting tool insert for parting, grooving and threading of steel and stainless steels comprising a substrate and a coating **characterised in that** the substrate comprises WC, 7.5-10.5 wt-% Co, 0.7-1.1 wt-% Cr and 100-300 ppm Ti, with a CW_Cr-ratio of 0.77-0.97, and a coercivity of 21-27 kA/m, the CW_Cr ratio being defined as CW_Cr= (magnetic-% Co +1.13*wt-% Cr)/wt-% Co,

   where magnetic-% Co is the weight percentage of magnetic Co, wt-% Cr is the weight percentage of Cr in the cemented carbide and wt-% Co is the weight percentage of Co in the cemented carbide, and, the coating comprises two (Ti,Al)N-layers with different Al/Ti-ratios: an inner $Al_yTi_{1-y}N$-layer with y=0.4-0.67, with a thickness of 0.3-2.5 $\mu$m, and an outer $Al_wTi_{1-w}N$ layer with w=0.15-0.35, with a thickness of 0.5-5.0 $\mu$m.

2. Cutting tool insert according to claim 1, **characterised in that** the substrate comprises 8.5-9.5 wt-% Co.

3. Cutting tool insert according to any one of claims 1-2, **characterised in that** the substrate comprises 0.8-1.0 wt-% Cr.

4. Cutting tool insert according to any one of claims 1-3, **characterised in that** the substrate comprises 200-260 ppm Ti.

5.  Cutting tool insert according to any one of claims 1-4, **characterised in that** the substrate has a CW_Cr-ratio of 0.82-0.92 and a coercivity of 22-26 kA/m.

6.  Cutting tool insert according to any one of claims 1-5, **characterised in that** y= 0.45-0.60 and w= 0.20-0.30.

7.  Cutting tool insert according to any one of claims 1-6, **characterised in that** the inner $Al_yTi_{1-y}N$-layer has a thickness of 0.5-2.0 $\mu$m and the outer $Al_wTi_{1-w}N$ layer has a thickness of 1.0-4.0 $\mu$m.

8.  Cutting tool insert according to any one of claims 1-7, c h a r a c t e r i s e d in that Ti in the substrate is partly replaced by Ta to a weight ratio Ti/Ta of $\geq$0.8, but $\leq$1.7

9.  Cutting tool insert according to any one of claims 1-8, c h a r a c t e r i s e d in that

    the inner layer is an aperiodic lamella coating consisting of alternating layers of $Al_zTi_{1-z}N$ and $Al_vTi_{1-v}N$ where z=0.55-0.70, and v=0.35-0.53, with a thickness of each individual layer 0.1-20 nm, and/or,
    the outer layer consists of an aperiodic lamella coating with alternating layers of $Al_mTi_{1-m}N$, $Al_nTi_{1-n}N$ and $Al_kTi_{1-k}N$ where m=0-0.2, n=0.35-0.53, k=0.55-0.70, with a thickness of each individual layer of 0.1-20 nm.

10. Cutting tool insert according to claim 9, c h a r a c t e r i s e d in that z=0.6-0.67 and v=0.40-0.50.

11. Cutting tool insert according to any one of claims 9-10, c h a r a c t e r i s e d in that m=0-0.1, n=0.40-0.50, and k=0.6-0.67.

12. Cutting tool insert according to any one of claims 9-11, c h a r a c t e r i s e d in that the inner layer and the outer layer both consist of aperiodic lamella coatings, wherein the thickness of each individual layer is 1-10 nm.

13. Cutting tool insert according to any one of claims 1-14, c h a r a c t e r i s e d in an innermost adhesion layer consisting of TiN with a thickness of 0.05-0.2 $\mu$m.

14. Method of making a coated cutting tool insert consisting of a cemented carbide substrate and a coating c h a r a c t e r i s e d in the following steps:

    - providing a substrate using conventional powder metallurgical techniques milling, pressing and sintering, comprising WC, 7.5-10.5 wt-% Co, 0.7-1.1 wt-% Cr, and 100-300 ppm Ti, with a CW_Cr-ratio of 0.77-0.97, and a coercivity of 21-27 kA/m, the CW_Cr ratio being defined as

$$\texttt{CW\_Cr= (magnetic-\% Co +1.13*wt-\%Cr)/wt-\%Co}$$

    where magnetic-% Co is the weight percentage of magnetic Co, wt-% Cr is the weight percentage of Cr and wt-% Co is the weight percentage of Co in the cemented carbide, and,
    - depositing using cathodic arc evaporation or magnetron sputtering a coating comprising two (Ti,Al)N-layers with different Al/Ti-ratios: an inner $Al_yTi_{1-y}N$-layer with y=0.4-0.67, with a thickness of 0.3-2.5 $\mu$m and an outer $Al_wTi_{1-w}N$ layer with w=0.15-0.35, with a thickness of 0.5-5.0 $\mu$m.

15. Method according to claim 14 **characterised in that** the substrate comprises 8.5-9.5 wt-% Co.

16. Method according to any one of claims 14-15 **characterised in that** the substrate comprises 0.8-1.0 wt-% Cr.

17. Method according to any one of claims 14-16, **characterised in that** the substrate comprises 200-260 ppm Ti.

18. Method according to any one of claims 14-17, **characterised in that** the substrate has a CW_Cr-ratio of 0.82-0.92 and a coercivity of 22-26 kA/m.

19. Method according to any one of claims 14-18, **characterised in that** for the inner $Al_yTi_{1-y}N$-layer, y=0.45-0.60, and for the outer $Al_wTi_{1-w}N$ layer, w=0.20-0.30.

**20.** Method according to any one of claims 14-19, **characterised in that** the inner $Al_yTi_{1-y}N$-layer has a thickness of 0.5-2.0 $\mu$m and the outer $Al_wTi_{1-w}N$ layer has a thickness of 1.0-4.0 $\mu$m.

**21.** Method according to any one of claims 14-20, **characterised in that** Ti in the substrate is partly replaced by Ta to a weight ratio Ti/Ta of $\geq$0.8, but $\leq$1.7.

**22.** Method according to any one of claims 14-21, **characterised in that** the inner layer is an aperiodic lamella coating consisting of alternating layers of $Al_zTi_{1-z}N$ and $Al_vTi_{1-v}N$ where z=0.55-0.70 and v=0.35-0.53, with a thickness of each individual layer being 0.1-20 nm, and/or the outer layer consists of an aperiodic lamella coating with alternating layers of $Al_mTi_{1-m}N$, $Al_nTi_{1-n}N$ and $Al_kTi_{1-k}N$ where m=0-0.2, n=0.35-0.53, k=0.55-0.70, with a thickness of each individual layer of 0.1-20 nm.

**23.** Method according to claim 22, **characterised in that** z=0.6-0.67 and v=0.40-0.50.

**24.** Method according to any one of claims 21-22, **characterised in that** m=0-0.1, n=0.40-0.50, and k=0.6-0.67.

**25.** Use of an insert according to any of claims 1-13 for parting, grooving and threading in steel and stainless steel under we conditions at a cutting speed of 30-400 m/min and a feed of 0.05-0.6 mm/rev.

**26.** Use of an insert according to any of claims 1-13 for parting, grooving and threading in HRSA under wet conditions at a cutting speed of 15-100 m/min and a feed of 0.02-0.3 mm/rev.

Europäisches
Patentamt
European
Patent Office
Office européen
des brevets

# EUROPEAN SEARCH REPORT

**Application Number**

EP 08 15 6044

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2006/041366 A (SANDVIK INTELLECTUAL PROPERTY [SE]; ASTRAND MARIA [SE]; SELINDER TORBJ) 20 April 2006 (2006-04-20) * page 2 - page 3 * ----- | 1-26 | INV. C23C14/06 C22C29/00 C23C16/34 C23C30/00 |
| A,P | EP 1 795 628 A (SANDVIK INTELLECTUAL PROPERTY [SE]) 13 June 2007 (2007-06-13) * claims 1-6; figure 1 * ----- | 1-26 | |
| A | EP 1 038 989 A (SANDVIK AB [SE]) 27 September 2000 (2000-09-27) * claim 1 * ----- | 1-26 | |
| A | WO 2006/080888 A (SANDVIK INTELLECTUAL PROPERTY [SE]; AHLGREN MATS [SE]; AAGREN TORBJOER) 3 August 2006 (2006-08-03) * claims 1-10 * ----- | 1-26 | |
| A | US 5 679 448 A (KAWATA KAZUKI [JP]) 21 October 1997 (1997-10-21) * claims 1-7 * ----- | 1-26 | TECHNICAL FIELDS SEARCHED (IPC) C22C C23C |

The present search report has been drawn up for all claims

| Place of search | Date of completion of the search | Examiner |
|---|---|---|
| Munich | 11 November 2008 | Badcock, Gordon |

EPO FORM 1503 03.82 (P04C01)

## ANNEX TO THE EUROPEAN SEARCH REPORT
## ON EUROPEAN PATENT APPLICATION NO.

EP 08 15 6044

This annex lists the patent family members relating to the patent documents cited in the above-mentioned European search report.
The members are as contained in the European Patent Office EDP file on
The European Patent Office is in no way liable for these particulars which are merely given for the purpose of information.

11-11-2008

| Patent document cited in search report | | Publication date | Patent family member(s) | | Publication date |
|---|---|---|---|---|---|
| WO 2006041366 | A | 20-04-2006 | CN | 1898406 A | 17-01-2007 |
| | | | EP | 1791986 A1 | 06-06-2007 |
| | | | JP | 2008512261 T | 24-04-2008 |
| | | | KR | 20070050862 A | 16-05-2007 |
| | | | US | 2007275179 A1 | 29-11-2007 |
| EP 1795628 | A | 13-06-2007 | CN | 1978192 A | 13-06-2007 |
| | | | JP | 2007196365 A | 09-08-2007 |
| | | | KR | 20070061456 A | 13-06-2007 |
| | | | SE | 0502694 A | 09-06-2007 |
| | | | US | 2007141346 A1 | 21-06-2007 |
| EP 1038989 | A | 27-09-2000 | AT | 269429 T | 15-07-2004 |
| | | | DE | 60011494 D1 | 22-07-2004 |
| | | | DE | 60011494 T2 | 28-10-2004 |
| | | | JP | 2000308916 A | 07-11-2000 |
| | | | SE | 519005 C2 | 17-12-2002 |
| | | | SE | 9901149 A | 27-09-2000 |
| | | | US | 6250855 B1 | 26-06-2001 |
| WO 2006080888 | A | 03-08-2006 | BR | PI0605876 A | 18-12-2007 |
| | | | CN | 101018891 A | 15-08-2007 |
| | | | EP | 1846590 A1 | 24-10-2007 |
| | | | JP | 2008512262 T | 24-04-2008 |
| | | | KR | 20070101201 A | 16-10-2007 |
| | | | SE | 528671 C2 | 16-01-2007 |
| | | | SE | 0500234 A | 01-08-2006 |
| | | | US | 2006286410 A1 | 21-12-2006 |
| US 5679448 | A | 21-10-1997 | DE | 4408250 A1 | 19-01-1995 |
| | | | JP | 2999346 B2 | 17-01-2000 |
| | | | JP | 7026381 A | 27-01-1995 |

EPO FORM P0459

For more details about this annex : see Official Journal of the European Patent Office, No. 12/82

**EP 2 011 894 A1**

**Patent documents cited in the description**

- US 6261673 B
- US 6342291 B
- EP 1798310 A